# EUROPEAN PATENT SPECIFICATION

(11) **EP 0 645 463 B1**
(45) Date of publication and mention of the grant of the patent: **29.12.1997**
(21) Application number: 94114746.4
(22) Date of filing: 19.09.1994
(51) Int. Cl.: C22C 14/00, F16J 9/26, C23C 14/02, C22F 1/18

(54) **TiAl-based intermetallic compound piston ring and process for treating the surfaces thereof**
Kolbenring aus TiAl basierender intermetallischer Verbindung und Verfahren zur Oberflächenbehandlung
Segment de piston en composé intermétallique à base de TiAl et procédé pour le traitement de surfaces

(30) Priority: 17.09.1993 JP 231449/93; 04.03.1994 JP 35082/94
(43) Date of publication of application: 29.03.1995
(73) Proprietor: HONDA GIKEN KOGYO KABUSHIKI KAISHA, Minato-ku, Tokyo (JP)
(72) Inventor: Fujiwara, Yoshiya, c/o Kabushiki Kaisha Honda, Wako-shi, Saitama (JP); Tokune, Toshio, c/o Kabushiki Kaisha Honda, Wako-shi, Saitama (JP); Kanoya, Izuru, c/o Kabushiki Kaisha Honda, Wako-shi, Saitama (JP)
(74) Representative: Liska, Horst, Dr.-Ing.

(56) References cited:
- PATENT ABSTRACTS OF JAPAN vol. 016 no. 145 (M-1233) ,10 April 1992 & JP-A-04 002702 (ISUZU MOTORS LTD) 7 January 1992,
- DATABASE WPI Section Ch, Week 1687 Derwent Publications Ltd., London, GB; Class M13, AN 87-112423 & JP-A-62 058 050 (TOYOTA JIDOSHA KK) , 13 March 1987
- PATENT ABSTRACTS OF JAPAN vol. 017 no. 503 (M-1478) ,10 September 1993 & JP-A-05 126255 (ATSUGI UNISIA CORP) 21 May 1993,
- DATABASE WPI Section Ch, Week 8716 Derwent Publications Ltd., London, GB; Class M13, AN 87-112423 & JP-A-62 058 050 (TOYOTA JIDOSHA KK) , 13 March 1987

## Description

### BACKGROUND OF THE INVENTION

### FIELD OF THE INVENTION

The present invention relates to a piston ring for use in an internal combustion engine, hydraulic system or the like, and particularly, to a piston ring formed from TiAl-based intermetallic compound, and to a process for treating the surfaces thereof.

### DESCRIPTION OF THE PRIOR ART

There are conventionally known piston rings for internal combustion engines, which are formed from stainless steels such as JIS SUS420J2 and the like (for example, see Japanese Patent Application Laid-open No. 35055/89).

Currently, the number of revolutions and output of the internal combustion engine have tended to increase, and in correspondence to this, a reduction in weight is demanded or the piston rings. However, if a stainless steel is used as a material for forming the piston ring, such demand cannot be satisfied. In addition, a following problem is encountered: because a fluttering phenomenon is generated at a particular number of revolutions (rpm) of the engine of, for example, about 5,000 rpm, due to the larger weight of the material, the amount of gas blown by and the amount of oil consumed are suddenly increased and hence, the limit of the maximum number of revolutions (rpm) is low whereby it is impossible to satisfy the demand for increasing the maximum revolution number (rpm) of the engine.

Moreover, if stainless steel is used for the piston ring, there is another problem in that the ability of the piston to radiate heat through the piston ring to the cylinder wall is poor, because stainless steel has a relatively low thermal conductivity at the temperature of the environment around the piston ring in a range of 250 to 350°C during operation of the engine.

Whereupon, it can be conceived that the piston ring may be advantageously formed from a titanium alloy, a fiber-reinforced metal material or an aluminum alloy for reducing the weight.

However, if the piston ring is formed from a titanium alloy, there is encountered a problem that the upper or lower surface of the piston ring or the inner surface of the ring groove is liable to be worn by sliding contact between the piston ring and the ring groove in the piston. And the ability of the piston to radiate heat through the piston ring to the cylinder wall is poor, because of a low thermal conductivity of the piston ring.

If the piston ring is formed from a fiber-reinforced metal material, another disadvantage is liable to arise, namely, a reinforcing fiber such as whisker or the like may cause wear of the inner surface of the ring groove in the piston to suddenly increase.

If the piston ring is formed from an aluminum alloy, the problems of the wear of the ring groove and the deterioration of the ability to radiate heat can be solved, but there is encountered a problem that a permanent set due to fatigue or the like is liable to be produced to generate a fluttering phenomenon, because of a low creep characteristic at a high temperature.

If the thickness of a top land of the piston is reduced to reduce the volume around the top land for receiving an exhaust gas, the amount of hydrocarbons discharged can be reduced, but if such means is employed, the thermal environment of the piston ring is very severe and hence, even with a piston ring formed of stainless steel, a fatigue is produced after use thereof for a long period.

There are known surface treating processes for a piston rings for internal combustion engines, which comprise subjecting a surface of a piston ring made of a steel to an ion plating which is a physical vapor deposition process, thereby forming a film of titanium nitride (for example, see Japanese Patent Application Laid-open No. 57868/82).

However, if the surface treating technique by the physical vapor deposition process for the above-described piston ring of steel is utilized directly for a piston ring formed from a TiAl-based intermetallic compound, a problem is encountered, namely, because the piston ring may have a residual strain produced therein in many cases due to casting, machining or the like, a deformation may occur in the piston ring due to such residual strain after the physical vapor deposition.

JP-A-04002702 discloses a method of manufacture of a Ti-Al alloy piston. Ti particles having a size of about 100 µm and Al particles having a size of about 10 µm are kneaded in an electrostatic vessel. By this method the Ti particles are coated with the Al particles, such that the Ti particles constitute the core. These particles are packed into a sintering chamber and under the application of a high-frequency current superimposed to a DC current and a pressure, the Ti-Al alloy pistons are formed. During this sintering process the Al particles are thermally diffused into the Ti particles in order to develop the Ti-Al alloy phase and such a piston having a low thermal expansion can be obtained.

JP-A-62058050 discloses a piston ring, including a compression ring and an oil seal ring. This piston ring is constituted of a multi-layered construction in which a superhard substance layer is formed on at least a peripheral sliding face, which is to be touched by the cylinder bore wall of an internal combustion engine, after forming a Ti film as an adhesive layer directly on the surface of a peripheral sliding face. On the surface of the superhard substance layer a TiN layer having a thickness of 1-5 micron is formed.

JP-A-05126255 discloses a piston pin having a body made of a Ti-Al intermetallic compound. Ti and Al are quenched and solidified at a synthetic reaction temperature and a fine mixed material of the titanium and the aluminium is manufactured. This mixed material is used for a reaction sintering method, during which method the mixed material generates the Ti-Al intermetallic compound constituting the piston pin body. Further a wear resistance coating may be formed on the surface of such a piston pin body.

### SUMMARY OF THE INVENTION

It is an object of the present invention to provide a piston ring of a TiAl-based intermetallic compound and a process for treating a surface of a piston ring, wherein the deformation of a piston ring formed of a TiAl-based intermetallic compound after physical vapor deposition can be reduced to the utmost, which piston ring has a high rigidity and exhibits a high thermal conductivity in a temperature range of 250 to 350°C during operation of an engine.

To achieve the above object, according to the present invention, there is provided a TiAl-based intermetallic compound piston ring formed from a TiAl-based intermetallic compound having a volume fraction Vf of γ-type TiAl of L1₀ structure represented by Vf ≧ 30 % .

If such TiAl-based intermetallic compound is used as a forming material, it is possible to improve the machinability of the piston ring, to achieve a reduction in weight thereof and further to increase the thermal conductivity thereof in the temperature range of 250 to 350°C.

Moreover, an increase in rigidity of the piston ring also can be achieved and therefore, the piston ring cannot be fractured when mounted to the piston and maintain the intended tension without generation of fatigue over a long period of time even at a high temperature, e.g., at 300°C, and therefore, has an excellent durability. Thus, it is possible to reduce the thickness of the top land in a piston to reduce the volume surrounding the top land and to reduce the amount of hydrocarbons discharged. In this case, the TiAl-based intermetallic compound has a specific gravity which is approximately one half of that of stainless steel, and a specific rigidity which is approximately twice that of stainless steel. Therefore, the inertial force of the piston ring formed from the TiAl-based intermetallic compound is approximately one half of that of a piston ring formed from stainless steel and having the same size, and the shock force applied to the ring groove is also reduced and hence, it is possible to reduce the volume surrounding the top land from the volume when the piston ring formed from stainless steel is used.

Further, as a result of an increase in rigidity and a reduction in weight, it is possible to inhibit the generation of a fluttering phenomenon of the piston ring to increase the limit of the number of revolutions (rpm) thereof, for example, up to about 8,000 to about 9,000 rpm.

However, if the volume fraction Vf of the L1₀ type TiAl is smaller than 30%, reductions in machinability, durability and limit of the number of engine revolutions (rpm) of the piston ring are brought about, and the piston ring is liable to be fractured when mounted to the piston.

According to the present invention, there is further provided a process for treating a surface of a piston ring made of a TiAl-based intermetallic compound having a volume fraction Vf of γ-phase TiAl of L1₀ structure represented by Vf ≥ 30%, comprising a step of forming a thin film on a surface of the piston ring by physical vapor deposition, wherein the residual strain of the piston ring is removed by subjecting the piston ring to a thermal treatment prior to the formation of the thin film by the physical vapor deposition.

If the thin film is formed on the piston ring by the physical vapor deposition after removal of the residual strain of the piston ring, the deformation of the piston ring after the physical vapor deposition due to the residual strain of the piston ring can be reduced to the utmost.

The above and other objects, features and advantages of the invention will become apparent from the following description of preferred embodiments taken in conjunction with the accompanying drawings.

### BRIEF DESCRIPTION OF THE DRAWINGS

Fig. 1 is a plan view of a piston ring according to this invention;
Fig. 2 is a sectional view taken along a line 2-2 in Fig. 1 ;
Fig. 3 is a graph illustrating the relationship between the number of revolutions of an engine (rpm) and the amount of gas blown-by;
Fig. 4 is a graph illustrating the relationship between the temperature and the thermal conductivity;
Fig. 5 is a graph illustrating the relationship between the time of exposure to a high temperature and the attenuation or reduction in tension;
Fig. 6 is a graph illustrating the relationship between the thickness of the top land of a piston and the variation in the amount of hydrocarbons discharged;
Fig. 7 is a perspective view of one example of a test piece;
Fig. 8 is an enlarged sectional view of a test piece having a thin film thereon;
Fig. 9 is a view for explaining a method for measuring a strain on the test piece;
Fig. 10 is a perspective view of another example of a test piece; and
Fig. 11 is a perspective view of a piston ring according to this invention.

### DESCRIPTION OF THE PREFERRED EMBODIMENTS

### A. Piston Ring of TiAl-based Intermetallic Compound

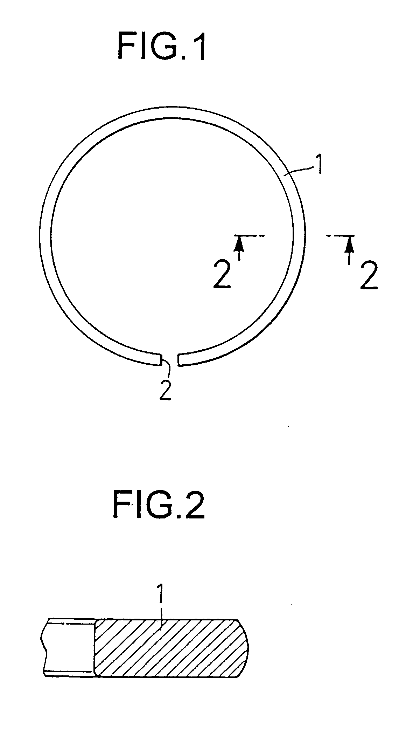

Referring to Figs.1 and 2, a top ring 1 as a piston ring for an internal combustion engine is formed from a TiAl-based intermetallic compound.

In producing the top ring 1, a process was employed which is comprised of the steps of: (a) preparing a blank having a purity of 99.9% or more and melting the blank in a plasma skull melting furnace to prepare a molten metal having a TiAl-based intermetallic compound composition, (b) subjecting the molten metal to a casting process to produce an ingot having a diameter of 100 mm and a height of 50 mm, (c) subjecting the ingot to a homogenization at 1,000°C for 72 hours in vacuum, (d) subjecting the ingot to a boring to conform to the shape of a top ring in a free state, (e) subjecting a resulting ingot to a cutting-off to produce a ring blank having a predetermined thickness, (f) subjecting an outer peripheral surface of the ring blank to a lathe-turning, (g) subjecting the resulting ring blank to a cutting to define a slit corresponding to a clearance 2, (h) subjecting an inner peripheral surface of the ring blank to a lathe-turning, (i) subjecting the cut surface and the outer and inner peripheral surfaces of the ring blank to a finishing, (j) subjecting the finished outer peripheral surface and opposite end faces of the ring blank to an ion plating treatment to form, for example, a TiN layer having a thickness of 5 µm, and (k) subjecting the outer peripheral surface of the ring blank to a lapping.

According to such a producing process, various top rings 1 were produced with different compositions and different volume fractions Vf of LI₀ type TiAl (which will be referred to as a γ-phase herein). For comparison, a top ring 1 formed from JIS SUS420J2 and a top ring 1 formed from Ti-6Al-4V (90% by weight Ti; 6% by weight Al and 4% by weight V) were also produced. These top rings 1 were examined for whether or not the quality of machinability was good, whether or not the top ring was fractured when being mounted to a piston and whether or not there was an attenuation of tension of the top ring after a high-temperature maintaining test (according to JIS B8032). A specific Young's modulus and a weight ratio of the top ring of the present invention to the top ring of the SUS420J2 were determined, thereby providing results given in Table 1. In the specific Young's modulus in Table 1, ρ is a specific gravity (g/cm³).

The volume fraction Vf of the γ-phase was calculated by analyzing a back scattering electron composition image to determine an area rate of the γ-phase and numerically calculating the area rate.

In Table 1, the quality of the machinability is represented by "O" when the lathe-turning, cutting and the like could be performed without hindrance in the producing course, and by "△" when any contrivance was required for a jig and a working way in the lathe-turning or the like.

When the piston ring 1 was stretched to mount on the piston, each example which was fractured is represented by "bad", and each example which was not fractured is represented by "good".

Whether or not there was an attenuation of tension is represented by "absence" when the tension was in an initially defined range and by "presence" when the tension of the top ring was out of the initially defined range, wherein the tension of the top ring 1 was measured by incorporating the piston with the top ring 1 mounted thereto into a cylinder of an internal combustion engine, heating them to 300°C for one hour and cooling them to ambient temperature. It should be noted that each top ring that was fractured during the mounting on the piston was omitted from the high-temperature maintaining test.

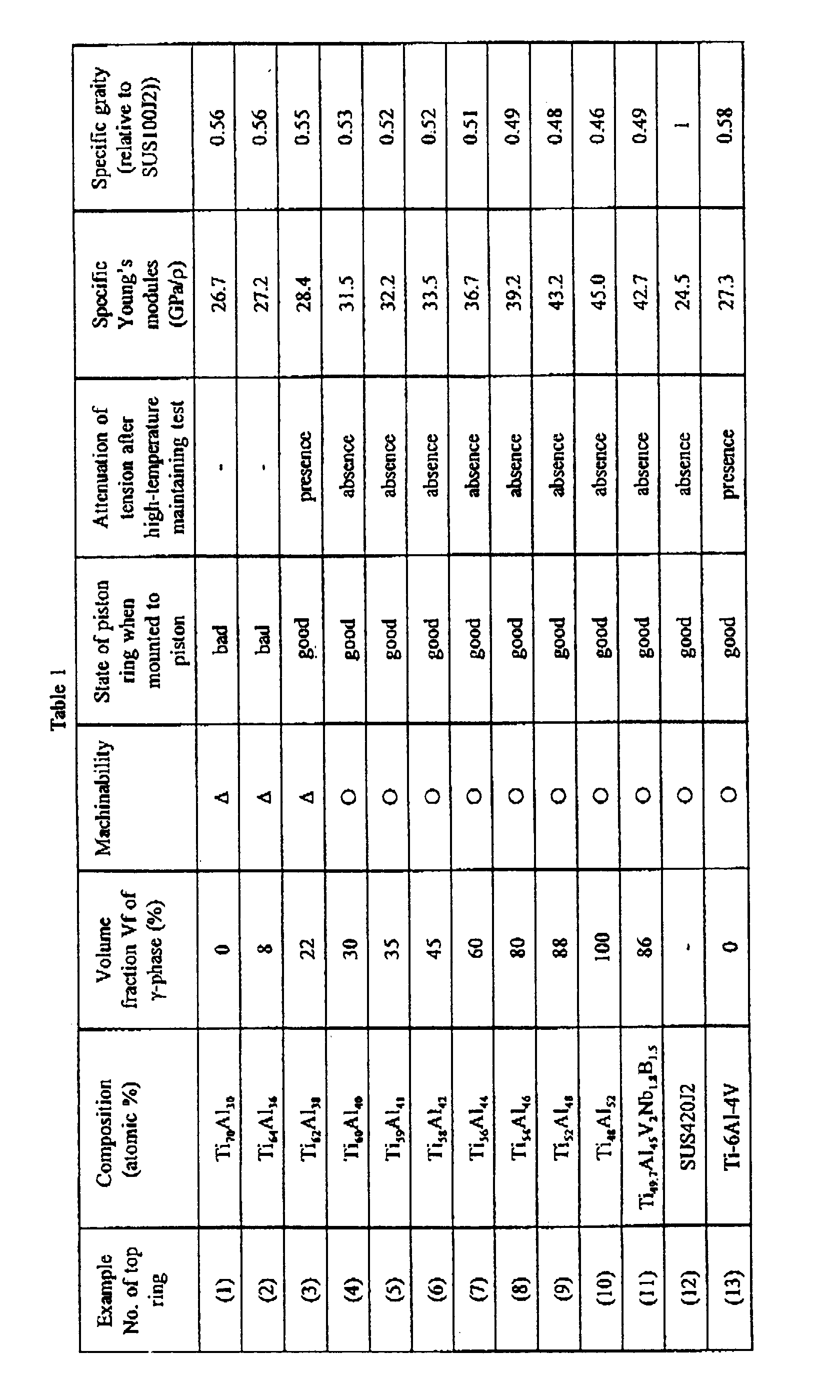

As is apparent from Table 1, if the TiAl-based intermetallic compound having a volume fraction Vf of γ-phase ≧ 30% is used as a forming material as in examples of the top rings (4) to (11), a reduction in weight and an increase in rigidity can be achieved; the machinability can be improved; the fracturing upon mounting of the piston ring on the piston can be prevented, and further, the attenuation of tension can be avoided even at a high temperature.

By the avoidance of the attenuation of tension, it is possible to insure a hermetic tightness to provide reductions in the amount of gas blown-by the piston and the amount of oil consumed, and it is ensured that the top ring 1 fulfills its intended function.

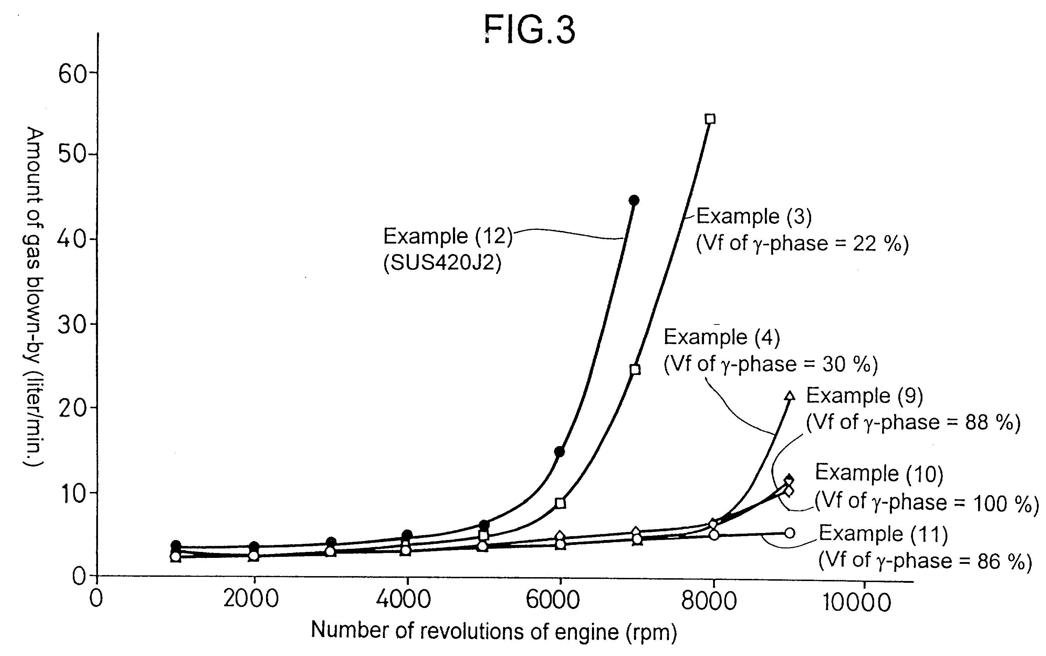

An engine simple firing test was carried out using the examples (4), (9) to (11) and the comparative examples (3) and (12) to determine the relationship between the number of revolutions of the engine (rpm) and the amount of gas blown-by, thereby providing the results shown in Fig. 3. The internal combustion engine used was a serial 4-cylinder gasoline engine having a bore diameter of 72 mm, a stroke of 76 mm and an engine displacement of 1236 cc. The term "engine simple firing test" means a test for estimating the characteristic of the engine by burning the gasoline to revolve the engine in the same manner as in the actual driving operation.

As is apparent from Fig. 3, in the case of the examples (4), (9) and (10), an increase in the amount of gas blown-by is observed at a number of revolutions of the engine (rpm) of about 8,000 rpm, which indicates that the limit of the number of revolutions for the example (4) and the like is about 8,000 rpm. Especially, with the example (11) the limit of the number of revolutions (rpm) is increased up to about 9,000 rpm or more.

In contrast, the limit of the number of revolutions for the comparative example (12) is as low as about 5,000 rpm. This is because a fluttering phenomenon is generated at a number of revolutions of the engine (rpm) equal to or more than about 5,000 rpm in the comparative example (12). A tendency substantially similar to that with the comparative example (12) is shown even with the comparative example (3), but an increase in the amount of gas blown-by in this case is due to an attenuation of tension.

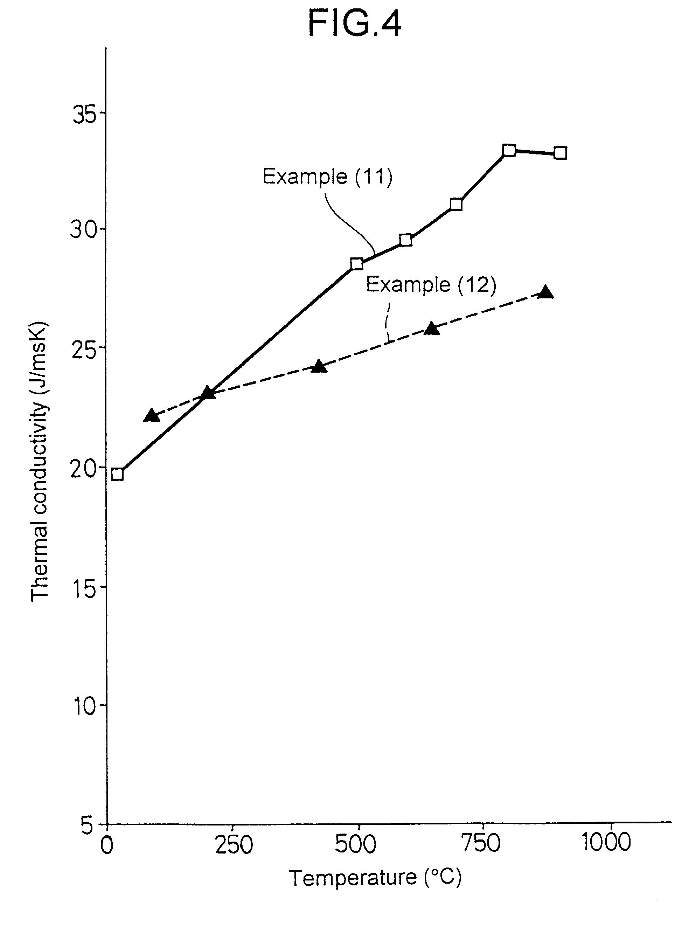

Fig. 4 shows the relationship between the temperature and the thermal conductivity for the example (11) of the present invention and the comparative example (12). It can be seen from Fig. 4 that the thermal conductivity of the example (11) is higher than that of the comparative example (12) at an environment temperature around the top ring in a range of 250 to 350°C during operation of the engine. Thus, it is possible to improve the heat radiation of the piston to the cylinder wall.

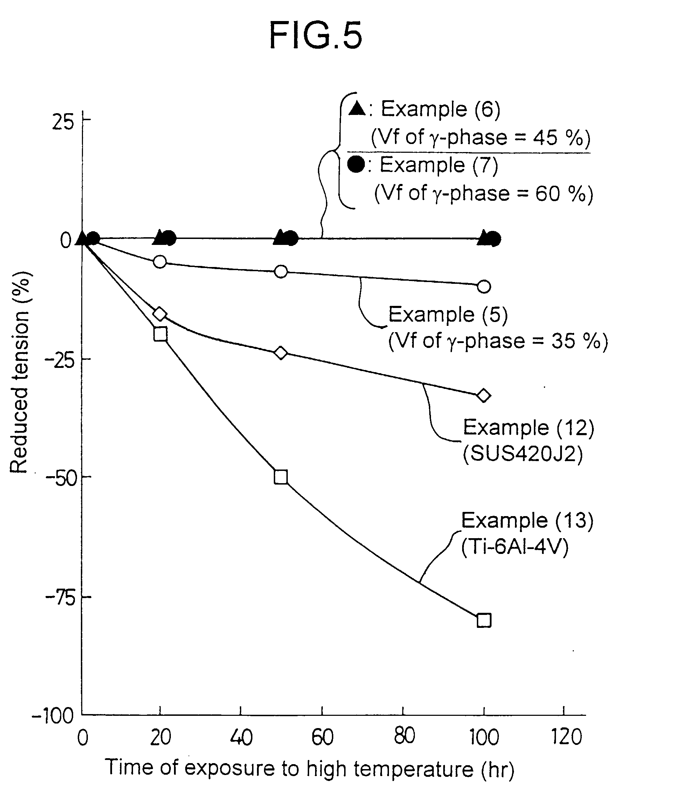

Fig. 5 shows the relationship between the time of exposure to a high temperature and the attenuation of tension for the examples (5), (6), (7), (12) and (13). The conditions for the high-temperature maintaining test are the same as those described above, except that the time of exposure to the high temperature is varied.

As apparent from Fig. 5, in the case of the examples (6) and (7) of the top ring 1, the attenuation of tension was not generated even if the they were used for a long period at a high temperature. In the case of the example (5), an attenuation of tension that varied slowly but gradually with passage of time was observed. This is due to the difference in volume fraction of the γ-phase. Therefore, in order to reliably avoid the attenuation of tension based on the use for the long period at the high temperature, it is necessary to set the volume fraction of the γ-phase in a range represented by Vf ≧ 40% as in the examples (6) and (7).

With the comparative examples (12) and (13) the variation in attenuation of tension with the passage of time is severe and continuous over the time period of the test.

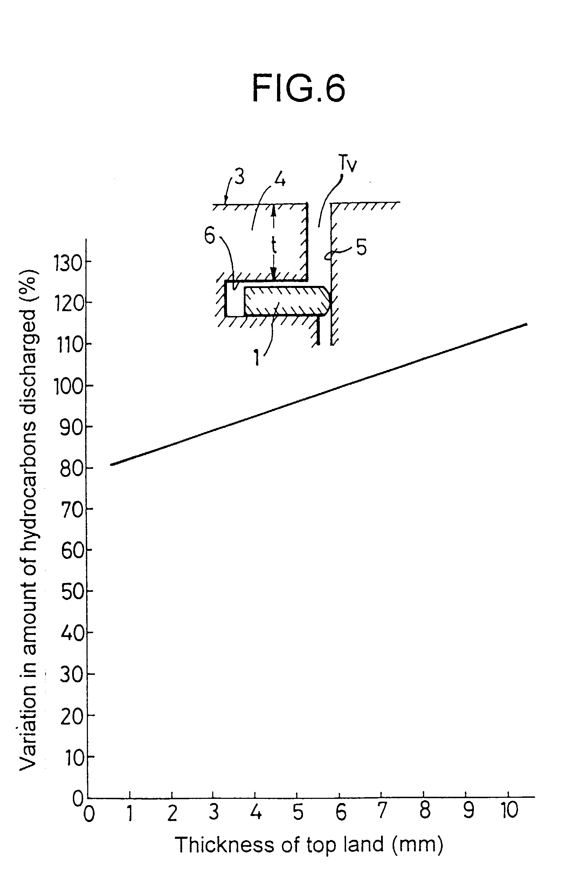

Fig. 6 illustrates the relationship between the thickness t of the top land 4 in the piston 3 and the variation in amount of hydrocarbons discharged. The conditions for operation of the engine were that the number of revolutions was 1,500 rpm and a partial opening operation (at a water temperature of 25°C). In Fig. 6, reference character 5 is a cylinder bore; reference character 6 is a ring groove; and reference character Tv is a top land volume.

It can be seen from Fig. 6 that as the thickness t of the top land 4 is decreased, the top land volume Tv is reduced and hence, the variation in amount of hydrocarbons discharged is reduced.

By using the examples (6) to (11) of the top ring 1 according to the present invention, it is possible to decrease the thickness t of the top land 4 down to a range of 2 mm ≦ t ≦ 4 mm to reduce the amount of hydrocarbons discharged.

### B. Surface treatment of piston ring made of TiAl-based intermetallic compound

A molten metal having a TiAl-based intermetallic compound composition represented by Ti_{49.6}AI₄₅V₂Nb₂B_{1.4} (each of the numerical values is atomic %) was prepared by a high-frequency induction skull melting using a water-cooled Cu crucible within a vacuum chamber, and subjected to a centrifugal casting process to produce a cylindrical ingot including a tapered hole and having an outside diameter of 90 mm, an inside diameter of 70 mm at one end, an inside diameter of 78 mm at the other end, and a length of 150 mm.

The ingot was subjected sequentially to a hot isostatic pressing process (HIP process) under conditions of 1300°C, 3 hours and 2,000 atmosphere, to a solution treatment under conditions of 1,200°C and 3 hours and to an aging treatment at 900°C for 8 hours.

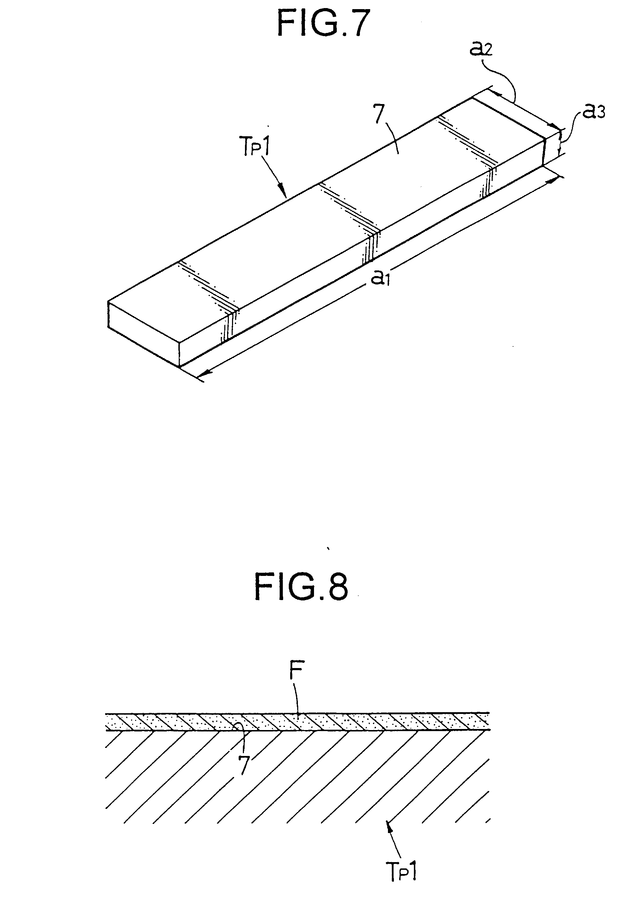

Then, the ingot was subjected to a machining, such as a milling, to fabricate a plurality of thin plate-like test pieces Tp1 shown in Fig. 7. Subsequently, one flat surface 7 of each of the test pieces Tp1 was subjected to a grinding finish to adjust the 10-point average roughness R_{Z} of the flat surface 7 to a value equal to 0.8 µm (R_{Z} = 0.8µm). The dimensions of each test piece Tp1 were a length a₁ = 50 mm, a width a₂ = 10 mm, and a thickness a₃ = 3 mm.

Each of the test pieces Tp1 was subjected to a thermal treatment in a vacuum for the purpose of removing the residual strain. In this case, the thermal treatment temperature T was set in a range of 300°C ≦ T ≦ 1,000°C, and the thermal treatment time was set at 8 hours.

The surface roughness Rₘₐₓ of one flat surface 7 of each test piece Tp1 was adjusted to a value equal to 0.6 S (Rₘₐₓ = 0. 6 S). Each of the test pieces was subjected to a bombard treatment for 10 minutes and then, the flat surface 7 was subjected to an ion-plating treatment as a physical vapor deposition to form a hard film F of titanium nitride (TiN) having a thickness of 10 µm. The ion-plating conditions were as follows: the atmospheric gas was nitrogen gas; the evaporation source was Ti; the arc current was 150 A; the bias voltage was 120 V; and the treating time was 60 minutes.

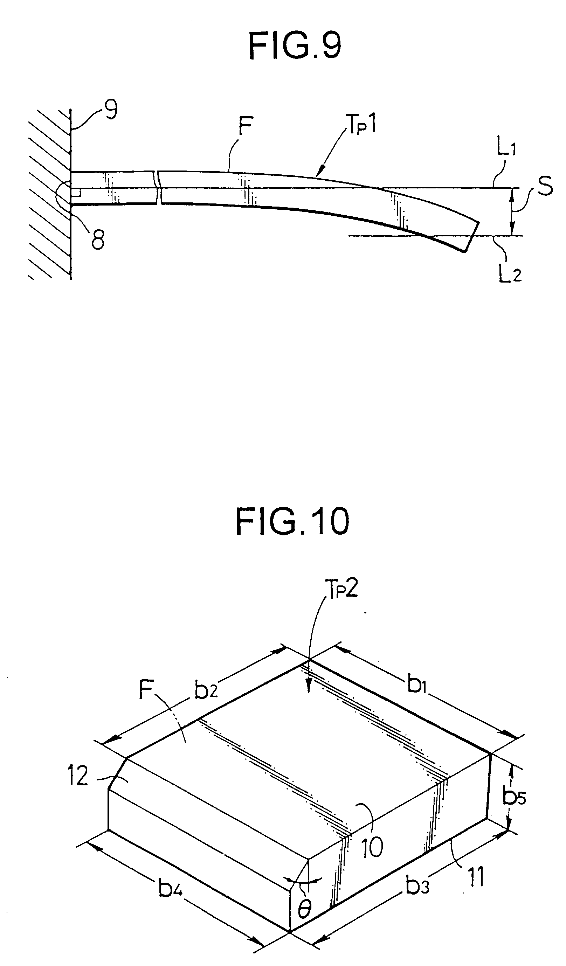

The strain of each test piece Tp1 after the ion-plating was measured in the following manner: as shown in Fig. 9, the test piece Tp1 after the ion-plating was fixed with the film side turned upwardly (or downwardly) and with one end face 8 abutting against a vertical surface 9. The distance between a reference horizontal line L₁ bisecting the fixed end of the test piece Tp1 in a widthwise direction and a horizontal line L₂ bisecting the free end of the test piece Tp1 in the thickness-wise direction is defined as a strain S.

Table 2 shows the relationship between the thermal treatment temperature T and the strain S after ion-plating for the examples (1) to (9) of the test pieces Tp1. In Table 2, the example (1) was not subjected to the thermal treatment for removing the residual strain after the machining.

**Table 2**

| Example No. of test piece Tp1 | Thermal treatment temperature (°C) | Strain S after ion-plating (mm) |
|---|---|---|
| (1) | - | 6.3 |
| (2) | 300 | 4.2 |
| (3) | 400 | 3.9 |
| (4) | 500 | 0.1 |
| (5) | 600 | 0.05 |
| (6) | 700 | 0.1 |
| (7) | 800 | 0.2 |
| (8) | 900 | 0.2 |
| (9) | 1,000 | 3.6 |

As is apparent from Table 2, if the thermal treatment temperature T was set in a range of 500°C ≦ T ≦ 900°C, the strain S after ion-plating was reduced to a small value less than 0.2 mm as in the examples (4) to (8). Especially, when the thermal treatment temperature T was set at 600°C, the strain S was minimized.

Then, the ingot was subjected to a machining after the aging treatment (at 900°C for 8 hours) to fabricate a plurality of smaller test pieces Tp2 shown in Fig. 10 in order to examine the relationship between the strain after the ion-plating and the sliding characteristic. Each of the test pieces Tp2 has a slant 12 formed at one side edge of one flat surface 10, so that the area of the one flat surface 10 is smaller than that of the other flat surface 11. The one flat surface 10 was subjected to a grinding finish to adjust the 10-point average roughness R₂ of the flat surface to a value of 0.8 µm. In the one flat surface 10 of each test piece Tp2, the length b₁ was 10 mm, and the width b₂ was 10 mm. In the other flat surface 11, the width b₃ was 11.5 mm, and the length b₄ was 10 mm. The angle θ of the slant 12 was 45° and the thickness b₅ thereof was 5 mm.

Each of the test pieces Tp2 was subjected to a thermal treatment in a vacuum for the purpose of removing the residual strain. In this case, the thermal treatment temperature was set in a range of 300°C ≦ T ≦ 1,000°C, and the thermal treatment time was set at 8 hours.

The surface roughness Rₘₐₓ of the one flat surface 10 of each test piece Tp2 was adjusted to a value equal to 0.6 S (Rₘₐₓ = 0.6 S). Each of the test pieces was subjected to a bombard treatment for 10 minutes and then, the flat surface 10 was subjected to an ion-plating to form a thin film F of titanium nitride (TiN) having a thickness of 10µm. The ion-plating conditions are the same as those described above, that is: the atmospheric gas was nitrogen gas; the evaporation source was Ti; the arc current was 150 A; the bias voltage was 120 V; and the treating time was 60 minutes.

Using the test pieces Tp2, a sliding test was carried out under lubrication in a chip-on-disk manner to examine the relationship between the thermal treatment temperature T and the seizure-generating surface pressure for the test pieces Tp2, thereby providing the results given in Table 3.

The sliding test was carried out under conditions of a rotational speed of the disk of 5 m/sec, the amount of oil supplied of 2 cc/min and the temperature of the oil of 80°C by disposing each of the test pieces Tp2 in such a manner that the slant 12 thereof was opposed to the rotating direction of the disk of a cast iron, and urging the thin film F of titanium nitride against the disk. The reason why the slant 12 is disposed as described above is for the purpose of facilitating the introduction of oil between the thin film F and the disk. The disk includes Si, Mn, V and P. In Table 3, the example 10 was not subjected to the thermal treatment for removing the residual strain.

**Table 3**

| Example No. of test piece Tp2 | Thermal treatment temperature (°C) | Seizure generating surface pressure (kgf/cm²) |
|---|---|---|
| (10) | - | 20 |
| (11) | 300 | 35 |
| (12) | 400 | 38 |
| (13) | 500 | 360 |
| (14) | 600 | 385 |
| (15) | 700 | 370 |
| (16) | 800 | 290 |
| (17) | 900 | 285 |
| (18) | 1,000 | 52 |

As apparent from Table 3, if the thermal treatment temperature T is set at a value in a range of 500° ≦ T ≦ 900°C, the strain S after the ion-plating is reduced in the examples (13) to (17) of test pieces Tp2, as in the examples (4) to (8) of Tp1 test pieces in Table 2. Therefore, the entire surface of the thin film F is put into uniform sliding frictional contact with the disk, resulting in a considerably increased seizure generating surface pressure. Especially, when the thermal treatment temperature T was set at 600°C, the seizure generating surface pressure was maximized, because the strain was minimized as described above. In the examples (10), (11), (12) and (18), the surface pressure is locally high because of the large strain S, resulting in an extremely reduced seizure generating surface pressure.

As other comparative examples, an example (19) of a test piece having a thin film of chromium nitride (Cr-N) formed thereon by an ion-plating treatment and an example (20) of a test piece having a thin film of titanium-aluminum nitride (TiAlN) likewise formed thereon by an ion-plating treatment were fabricated. The materials for both the test pieces (19) and (20) were the same as for the test pieces Tp1 and Tp2. With the thin film of chromium nitride, chromium (Cr) was used as an evaporation source, and with the thin film of titanium aluminum nitride, Ti₅₀Al₅₀ (each of the numerical values is atomic %) was used as an evaporation source.

Table 4 shows the thermal treatment temperature T, the strain S after the ion-plating, and the seizure generating surface pressure for the examples (19) and (20). The conditions for measuring the strain S and the conditions for the sliding test were the same as those described above.

**Table 4**

| Example No. of test piece | Thermal treatment temperature (°C) | Strain S after ion-plating (mm) | Seizure generating surface pressure (kgf/cm²) |
|---|---|---|---|
| (19) | 600 | 0.07 | 365 |
| (20) | 600 | 0.05 | 470 |

As apparent from comparison of Tables 2 and 3 with Table 4, if the material for the thin film is changed, the strain S may be changed in some cases, and the seizure generating surface pressure is varied depending upon the material for the thin film.

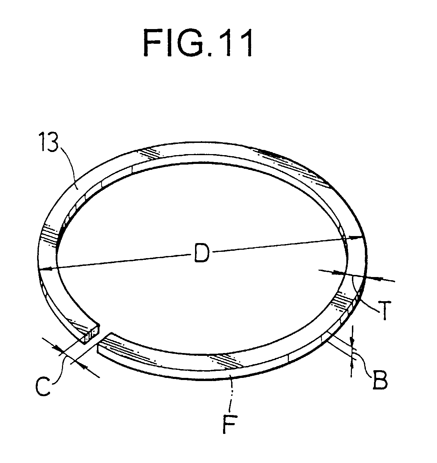

A particular example will now be described. An ingot of an intermetallic compound (Ti_{49.6}Al₄₅V₂Nb₂B_{1.4}) resulting from the aging treatment was subjected to a machining to fabricate a piston ring 13 for a gasoline engine as shown in Fig. 11. The size of the piston ring 13 was as follows: nominal outside diameter D = 81 mm; width B = 1 mm; thickness T = 3.1 mm; and distance of the clearance C between the two opposed ends = 0.2 to 0.35 mm when in the cylinder (distance of the clearance C in this free condition or original condition = 11.5 mm). In addition, the volume fraction Vf of LI₀ type TiAl in this piston ring 13 was 88%.

The piston ring 13 was subjected to a thermal treatment under conditions of a thermal treatment temperature T of 600°C for 8 hours for the purpose of removing the residual strain.

The surface roughness Rₘₐₓ of the piston ring 13 was adjusted to a value equal to 0.6 S (Rₘₐₓ = 0.6 S). The piston ring 13 was subjected to a bombard treatment or 10 minutes and then to an ion-plating treatment to form a thin film F of titanium nitride thereon. The thickness of the thin film F was 10 µm at the outer peripheral surface of the piston ring 13, and 3 µm at the opposite ends of the piston ring 13 which form the clearance C, the lower and upper surfaces of the piston ring 13 and at the inner peripheral surface of the piston ring 13. The ion-plating conditions were the same as those described above, that is: the atmospheric gas was nitrogen gas; the evaporation source was Ti; the arc current was 150 A; the bias voltage was 120 V; and the treating time was 60 minutes.

The piston ring 13 produced in this manner was incorporated as a top ring into a 4-cylinder gasoline engine having a displacement of 1,600 cc. In this case, a cylinder sleeve was formed from a cast iron (Fe-C-Si-Mn-V-P) which is the same material as for the disk in the sliding test described above, and the piston was formed from an aluminum alloy (JIS AC8C).

The gasoline engine was operated to perform a durability test for 400 hours. The results showed that an abnormal wear was not observed in the piston ring 13, the cylinder sleeve or the piston, and the attenuation of tension in the piston ring 13 was zero.

While specific embodiments of the invention have been described having specific compositions, dimensions, surface treatments, temperature treatments and the like, other embodiments will readily appear to those skilled in the art as being within the scope of the present invention as defined by the following claims.

## Claims

1. A piston ring formed of a TiAl-based intermetallic compound having a volume fraction Vf of γ-phase TiAl of L1₀ structure represented by Vf ≥ 30%.

2. A piston ring according to claim 1,
wherein said volume fraction Vf of γ-phase TiAl of L1₀ structure is in a range represented by Vf ≥ 40%.

3. A piston ring according to claim 1 or 2,
wherein said TiAl-based intermetallic compound is substantially Ti_{49,6}Al₄₅V₂Nb₂B_{1,4}.

4. A piston ring according to claim 1 or 2,
wherein a thin film is formed on a surface of the piston ring by a physical vapor deposition, and wherein said piston ring is subjected to a thermal treatment prior to the formation of said thin film for removing a residual strain in said piston ring.

5. A piston ring according to claim 4,
wherein a thermal treatment temperature T in said thermal treatment is set in a range represented by 500°C ≤ T ≤ 900°C.

6. A piston ring according to claim 4 or 5,
wherein said physical vapor deposition is an ion-plating.

7. A piston ring according to claim 4 or 5,
wherein said thin film is formed of a nitride selected from the group consisting of titanium nitride, chromium nitride and titanium-aluminum nitride.

8. A process for treating a surface of a piston ring, which piston ring is made of a TiAl-based intermetallic compound having a volume fraction Vf of γ-phase TiAl of L1₀ structure represented by Vf ≥ 30%, the process comprising the step of forming a thin film on a surface of the piston ring by a physical vapor deposition, wherein a residual strain in said piston ring is removed by subjecting said piston ring to a thermal treatment prior to the formation of the thin film by said physical vapor deposition.

9. A process according to claim 8,
wherein a thermal treatment temperature T in said thermal treatment is set in a range represented by 500°C ≤ T ≤ 900°C,

10. A process according to claim 8 or 9,
wherein said physical vapor deposition is an ion-plating.

11. A process according to anyone of claims 8 to 10, wherein said thin film is formed of a nitride selected from the group consisting of titanium nitride, chromium nitride and titanium-aluminum nitride.

12. A process according to claim 8 or 9,
wherein said TiAl-based intermetallic compound is Ti_{49,6}Al₄₅V₂Nb₂B_{1,4^{.}}

## Patentansprüche

1. Kolbenring, welcher aus einer intermetallischen Zusammensetzung auf TiAl-Basis gebildet ist, die einen Volumenanteil Vf von *y*-Phase-TiAl mit L1₀-Struktur von Vf ≥ 30 % aufweist.

2. Kolbenring nach Anspruch 1, worin der Volumenanteil Vf des *y*-Phase-TiAl mit L1₀-Struktur im Bereich von Vf ≥ 40 % liegt.

3. Kolbenring nach Anspruch 1 oder 2, worin die intermetallische Zusammensetzung auf TiAl-Basis im wesentlichen Ti_{49,6}Al₄₅V₂Nb₂B_{1,4} ist.

4. Kolbenring nach Anspruch 1 oder 2, worin ein dünner Film an einer Oberfläche des Kolbenrings durch eine physikalische Dampfabscheidung gebildet ist, und worin der Kolbenring vor dem Bilden des dünnen Films einer thermischen Behandlung unterzogen wird, um eine Restspannung in dem Kolbenring zu entfernen.

5. Kolbenring nach Anspruch 4, worin eine thermische Behandlungstemperatur T bei der thermischen Behandlung im Bereich von 500 °C ≤ T ≤ 900 °C eingestellt ist.

6. Kolbenring nach Anspruch 4 oder 5,
worin die physikalische Dampfabscheidung ein lonenplattieren ist.

7. Kolbenring nach Anspruch 4 oder 5,
worin der dünne Film aus einem Nitrid gebildet ist, das aus der Gruppe ausgewählt ist, die umfaßt: Titannitrid, Chromnitrid oder Titan-Aluminium-Nitrid.

8. Verfahren zur Behandlung einer Oberfläche eines Kolbenrings, welcher Kolbenring aus einer intermetallischen Zusammensetzung auf TiAl-Basis mit einem Volumenanteil Vf von *y*-Phase-TiAl mit L1₀-Struktur von Vf ≥ 30 % hergestellt wird, wobei das Verfahren den Schritt des Bildens eines dünnen Films an einer Oberfläche des Kolbenrings durch physikalische Dampfabscheidung umfaßt, wobei eine Restspannung in dem Kolbenring durch Unterziehen des Kolbenrings einer thermischen Behandlung vor dem Bilden des dünnen Films durch physikalische Dampfabscheidung entfernt wird.

9. Verfahren nach Anspruch 8, worin eine thermische Behandlungstemperatur T bei der thermischen Behandlung in einem Bereich von 500 °C ≤ T ≤ 900 °C eingestellt wird.

10. Verfahren nach Anspruch 8 oder 9, worin die physikalische Dampfabscheidung ein lonenplattieren ist.

11. Verfahren nach einem der Ansprüche 8 bis 10, worin der dünne Film aus einem Nitrid gebildet wird, das aus der Gruppe ausgewählt ist, die umfaßt: Titannitrid, Chromnitrid und Titan-Aluminium-Nitrid.

12. Verfahren nach Anspruch 8 oder 9, worin die intermetallische Zusammensetzung auf TiAl-Basis Ti_{49,6}Al₄₅V₂Nb₂B_{1,4} ist.

## Revendications

1. Segment de piston formé d'un composé intermétallique à base de TiAl ayant une fraction en volume Vf de TiAl en phase γ de structure L1₀ représentée par Vf ≥ 30%.

2. Segment de piston selon la revendication 1, dans lequel ladite fraction en volume Vf de TiAl en phase γ de structure L1₀ se situe dans la gamme représentée par Vf ≥ 40%.

3. Segment de piston selon la revendication 1 ou 2, dans lequel ledit composé intermétallique à base de TiAl est essentiellement Ti_{49,6}Al₄₅V₂Nb₂B_{1,4}.

4. Segment de piston selon la revendication 1 ou 2, dans lequel un film mince est formé à une surface du segment de piston par déposition en phase gazeuse par procédé physique, et dans lequel ledit segment de piston est soumis à un traitement thermique avant la formation dudit film mince pour éliminer une déformation résiduelle dans ledit segment de piston.

5. Segment de piston selon la revendication 4, dans lequel la température de traitement thermique T dans ledit traitement thermique est fixée dans une gamme représentée par 500°C ≤ T ≤ 900°C.

6. Segment de piston selon la revendication 4 ou 5, dans lequel ladite déposition en phase gazeuse par procédé physique est un placage ionique.

7. Segment de piston selon la revendication 4 ou 5, dans lequel ledit film mince est formé d'un nitrure choisi dans le groupe constitué par le nitrure de titane, le nitrure de chrome et le nitrure de titane-aluminium.

8. Procédé de traitement de surface d'un segment de piston, ledit segment de piston étant formé d'un composé intermétallique à base de TiAl ayant une fraction en volume Vf de TiAl en phase γ de structure L1₀ représentée par Vf ≥ 30%, le procédé comprenant l'étape consistant à former un film mince à la surface du segment de piston par déposition en phase gazeuse par procédé physique, dans lequel on élimine une déformation résiduelle dans ledit segment de piston en soumettant ledit segment de piston à un traitement thermique avant la formation du film mince par ladite déposition en phase gazeuse par procédé physique.

9. Procédé selon la revendication 8, dans lequel la température de traitement thermique T dans ledit traitement thermique est fixée dans une gamme représentée par 500°C ≤ T ≤ 900°C.

10. Procédé selon la revendication 8 ou 9, dans lequel ladite déposition en phase gazeuse par procédé physique est un placage ionique.

11. Procédé selon l'une quelconque des revendications 8 à 10, dans lequel ledit film mince est formé d'un nitrure choisi dans le groupe constitué par le nitrure de titane, le nitrure de chrome et le nitrure de titane-aluminium.

12. Procédé selon la revendication 8 ou 9, dans lequel ledit composé intermétallique à base de TiAl est essentiellement Ti_{49,6}Al₄₅V₂Nb₂B_{1,4}.
